# FASCICULE DE BREVET EUROPEEN

(11) **EP 0 735 489 B1**
(45) Date de publication et mention de la délivrance du brevet: **23.06.1999**
(21) Numéro de dépôt: 96470004.1
(22) Date de dépôt: 06.03.1996
(51) Int. Cl.: G06F 12/14, G11C 8/00

(54) **Procédé de protection de zones de mémoires non volatiles**
Verfahren zum Schützen nichtflüchtiger Speicherbereiche
Method of protecting zones of non-volatile memories

(30) Priorité: 31.03.1995 FR 9503863
(43) Date de publication de la demande: 02.10.1996
(73) Titulaire: STMicroelectronics S.A., 94250 Gentilly (FR)
(72) Inventeur: Tailliet, François, 57000 Metz (FR)
(74) Mandataire: Schmit, Christian Norbert Marie

(56) Documents cités:
- EP-A- 0 326 053
- WO-A-94/15320

## Description

L'invention concerne les mémoires électroniques non volatiles, effaçables et inscriptibles électriquement (EEPROMs), notamment mais non exclusivement celles qui sont destinées à être incorporées à des cartes à puces.

Dans beaucoup d'applications de circuits électroniques utilisant des mémoires non volatiles, on souhaite empêcher l'accès à certaines zones de mémoire, sans interdire pour autant l'accès à d'autres zones.

Un cas d'application typique auquel on se référera dans toute la suite de la description est le cas d'un circuit de carte à puce : le circuit est fabriqué par une première personne qui est le fabricant; il est acheté par un client pour une application donnée dans laquelle le circuit est incorporé à une carte à puce; cette carte est mise par le client à disposition d'un utilisateur pour des applications telles que la fourniture de biens ou services, le contrôle d'accès, etc. Les programmes de fonctionnement et certaines données sont définies par le client et inscrites ou modifiées uniquement sous son contrôle. Elles ne doivent pas pouvoir être modifiées, que ce soit volontairement ou involontairement, par l'utilisateur. D'autres données de la mémoire doivent cependant rester accessibles et modifiables par l'utilisateur.

On prévoit donc que les mémoires EEPROM peuvent fonctionner en mode protégé : une partie de la mémoire est protégée; l'autre est d'accès libre. Dans ce qui suit on parlera uniquement de protection en écriture (interdiction de modifier le contenu de la zone protégée), mais l'invention serait transposable à une protection en lecture (interdiction de lecture de la zone protégée), ou encore à la fois en lecture et en écriture.

La protection en écriture permet d'éviter une modification frauduleuse de données par l'utilisateur, ou une modification fortuite par des signaux parasites dans la circuiterie (par exemple lors d'une séquence de remise sous tension du circuit) ou par des erreurs ou instabilités de programmes de fonctionnement lorsque c'est un microprocesseur interne ou externe à la carte qui contrôle la mémoire, par exemple comme indiqué dans le document WO-A-9415320.

Le fabricant du circuit de mémoire ne sait pas a priori quelle dimension de mémoire doit être protégée et quelle dimension doit être laissée libre pour l'utilisateur. En effet, les dimensions respectives dépendent de l'application. C'est le client du circuit et non le fabricant ou l'utilisateur final qui peut les définir. Cependant, il est souhaitable qu'un seul type de circuit puisse être fabriqué indépendamment de l'application envisagée par le client. Si ce n'était pas le cas, le fabricant devrait lancer des séries de fabrication différentes pour des clients différents ou des applications différentes, même si les circuits sont identiques en tous points à l'exception de cette question de dimension de zone protégée.

On prévoit donc des moyens, à la disposition du client, pour définir quelle est la partie de mémoire qui doit être protégée. Le client peut alors, après avoir inscrit les informations à protéger dans une partie de la mémoire, mettre en service la protection sur cette partie.

Dans l'art antérieur, on a déjà proposé d'utiliser pour cela une instruction codée spéciale destinée au microprocesseur qui contrôle le circuit de mémoire comme indiqué par exemple dans le document EP-A-0 326 053. Cette instruction permet de mettre en mémoire, dans un registre non volatile extérieur à la moire proprement dite, une information précisant quelle est la zone de mémoire protégée et quelle est la zone non protégée. Parfois, cette information est stockée en partie dans un registre non volatile et en partie sous forme de câblage dur : par exemple les poids faibles d'une adresse de début de zone protégée sont stockés dans le registre, et les poids forts de cette adresse sont mémorisés en connectant une ou deux broches extérieures du circuit intégré à Vcc ou à la masse selon les bits à mémoriser. Ces solutions s'avèrent à l'usage peu commodes pour le client.

On a également proposé, dans le cas où aucune instruction spécifique de microprocesseur n'est disponible, de définir la zone protéqée par une succession d'instructions dont la combinaison est normalement impossible ou très improbable. De cette manière, il est peu vraisemblable qu'une séquence de définition de zone protégée puisse se produire fortuitement ou même frauduleusement. Cependant ce n'est pas impossible, et de toutes façons la mise en oeuvre est peu commode pour le client qui veut définir la zone protégée.

Un but de l'invention est de mettre à disposition du client des moyens plus commodes pour réaliser une partition désirée de la mémoire entre zone protégée et zone non protégée.

Selon l'invention, on propose un procédé pour réaliser une partition d'une mémoire entre une zone protégée et une zone non protégée, dans un circuit intégré à mémoire comportant des moyens pour empêcher ou autoriser un accès à des adresses de mémoire selon qu'elles sont situées dans la zone protégée ou dans la zone non protégée, la zone protégée étant définie par deux adresses d'extrémité de zone dont l'une est prédéterminée et l'autre est à choisir, ce procédé comportant les opérations consistant à :
a) écrire dans la mémoire à des adresses successives dans la zone protégée désirée,
c) effectuer une dernière opération d'écriture à l'adresse prédéterminée représentant une extrémité de la zone protégée;
caractérisé en ce que, entre l'étape a) et c), on effectue l'étape b) consistant à écrire automatiquement dans un registre volatile initialement la valeur de la première adresse à laquelle on a écrit;
et en ce que, après l'étape c), on effectue l'étape d) consistant à transférer automatiquement vers un registre non volatile l'adresse contenue dans le registre volatile, lors de l'opération d'écriture dans l'adresse prédéterminée, la zone protégée étant dès lors comprise entre l'adresse placée dans le registre non volatile et l'adresse prédéterminée.

L'adresse contenue dans le registre volatile peut, comme on l'expliquera plus loin, être stable pendant toute la procédure ou, au contraire, évoluer entre les opérations b et c.

En d'autres mots, au lieu d'obliger le client à établir une procédure spéciale de définition de zone protégée, avant ou après avoir écrit les informations sensibles dans cette zone, on se contente d'écrire dans la mémoire les informations sensibles à protéger, et c'est tout simplement l'ordre de succession des adresses d'écriture qui définit quelle est exactement la zone protégée. Il n'y a pas d'instruction spéciale de protection de zone; seules des instructions normales d'écriture dans la mémoire sont effectuées. Ceci est particulièrement commode pour le client.

On peut donc définir également l'invention de la manière suivante : un procédé de partition d'une mémoire entre une zone protégée de dimension non déterminée a priori, contenant des informations sensibles, et une zone non protégée, dans un circuit intégré comportant des moyens pour limiter l'accès à la mémoire dans la zone protégée, caractérisé en ce qu'une extrémité de la zone protégée est prédéterminée avant l' opération de partition, l'autre extrémité étant indéterminée, en ce que l'opération de partition consiste à écrire les informations sensibles dans les adresses de la zone protégée souhaitée, la dernière opération d'écriture étant effectuée à l'adresse de l'extrémité prédéterminée, et en ce que cette dernière opération d'écriture déclenche automatiquement le stockage dans un registre non-volatile d'une adresse spécifique définie à partir des adresses dans lesquelles on a écrit les informations sensibles, cette adresse spécifique définissant l'autre extrémité de la zone protégée.

Plusieurs variantes de mise en oeuvre sont possibles et feront mieux comprendre l'invention; on en donnera plus loin des exemples détaillés.

L'exemple le plus simple est le suivant: l'adresse finale prédéterminée est la dernière adresse ADF de la mémoire. Le client veut une zone protégée entre une adresse de départ ADP et l'adresse finale ADF. Pour cela il écrit les informations à protéger dans cette zone et les seules contraintes qu'il doit respecter sont les suivantes : commencer par l'adresse ADP et terminer par l'adresse ADF. C'est le fait d'écrire en commençant par l'adresse ADP qui mémorise provisoirement l'adresse ADP dans le circuit. Et c'est le fait d'écrire dans l'adresse ADF qui déclenche une procédure automatique, invisible pour le client, de stockage définitif de l'adresse ADP dans un registre non volatile qui définit la partition de la mémoire.

Un autre exemple, nécessitant une circuiterie de mise en oeuvre légèrement plus complexe, peut être donné succinctement ici pour illustrer la généralité de l'invention: la zone protégée est la zone comprise entre d'une part la plus petite adresse utilisée par le client au cours de la programmation dans la zone protégée et d'autre part l'adresse finale de la mémoire. Dans ce cas, entre les étapes b et c définies ci-dessus, on insère l'étape récurrente b1 consistant à modifier à chaque écriture le contenu du registre volatile pour y placer la plus faible des deux valeurs suivantes: adresse en cours d'écriture et adresse contenue dans le registre. Au moment où on écrit dans la dernière adresse ADF de la mémoire (ou toute autre adresse prédéterminée), le contenu du registre volatile, transféré automatiquement dans le registre non volatile, représente la plus petite des adresses à laquelle on a écrit au cours de cette opération. Là encore, la zone protégée est définie uniquement par les opérations d'écriture dans cette zone.

Ainsi, le coeur de l'invention est une procédure automatique de définition de partition entre zone protégée et zone non protégée, dans laquelle le seul fait d'écrire les informations à protéger définit une extrémité de la zone protégée, l'autre extrémité étant prédéfinie et imposée.

Cette procédure suppose seulement que l'une des extrémités de la zone protégée est prédéterminée, c'est-à-dire que la configuration du circuit au moment de l'opération de partition permet de reconnaître la réception d'un ordre d'écriture à cette adresse pour déclencher la partition automatique.

Outre le procédé de partition défini ci-dessus, la présente demande de brevet vise également à protéger un circuit à mémoire comportant des moyens adaptés à ce procédé.

On propose donc ici également un circuit intégré à mémoire comportant des moyens pour limiter l'accès à une zone protégée de la mémoire, ces moyens utilisant un registre non-volatile contenant une adresse d'extrémité de la zone protégée, caractérisé en ce que le circuit comporte des moyens pour définir une partition souhaitée de la mémoire entre cette zone protégée et une zone non protégée, ces moyens comportant un séquenceur, activé automatiquement par une opération d'écriture dans une adresse prédéterminée de la mémoire après des opérations d'écriture d'informations dans une série d'autres adresses de la zone protégée souhaitée, pour stocker dans le registre non-volatile une adresse spécifique définie automatiquement dans le circuit à partir des adresses de la série.

D'autres caractéristiques et avantages de l'invention apparaîtront à la lecture de la description détaillée qui suit et qui est faite en référence aux dessins annexés dans lesquels :
- la figure 1 représente la configuration des zones de la mémoire;
- la figure 2 représente un circuit intégré permettant la mise en oeuvre de l'invention;
- la figure 3 représente une variante de réalisation du circuit.

On décrira l'invention à propos d'un exemple particulier de mémoire EEPROM de 16 kilobits, dans laquelle la première moitié au moins de la mémoire reste libre d'accès, et une partie de la deuxième moitié peut être protégée lorsque le mode protégé est activé, la dimension de la partie protégée étant définie par le client lorsqu'il inscrit les informations sensibles dans cette partie. La protection est une protection classique en écriture.

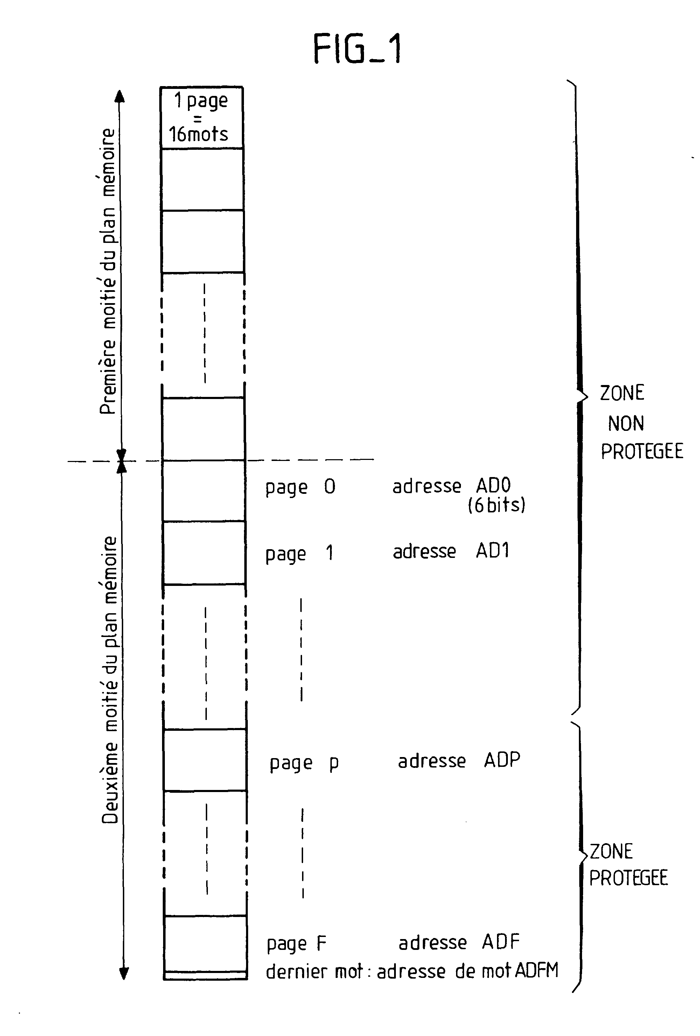

La mémoire est organisée (figure 1) en pages de 16 mots de 8 bits, et la zone protégée peut être définie avec une résolution d'une page et non pas d'un mot. Mais on pourrait évidemment prévoir aussi une résolution d'un mot si on le désirait. L'intérêt d'une résolution d'une page est de limiter le nombre de bits d'adresse qui doivent être stockés pour définir les extrémités de la zone protégée. Ici, l'adresse de page est définie par 7 bits. L'adresse de mot par quatre bits supplémentaires de poids faibles.

Dans cet exemple, la zone protégée est nécessairement dans la deuxième moitié de la mémoire; par conséquent le bit de poids fort d'adresse d'extrémité de zone protégée est figé et n'a pas besoin d'être mémorisé. Six bits restent nécessaires pour définir une adresse d'extrémité de zone protégée. Dans ce qui suit, on considérera donc comme adresse d'extrémité de zone protégée une adresse de page composée seulement des six bits strictement nécessaires pour définir cette adresse avec la résolution considérée. Mais il va de soi que d'autres organisations sont possibles.

Selon l'invention, une des extrémités de zone protégée est prédéterminée.

L'autre extrémité de la zone protégée est définie directement et automatiquement par le processus d'écriture des informations sensibles dans la mémoire.

Le client se contente alors d'inscrire les informations sensibles dans la zone protégée. La zone sera effectivement protégée à la fin de cette écriture des informations sensibles, comme on va l'expliquer.

### Premier mode de mise en oeuvre :

Dans l'exemple le plus simple, l'extrémité prédéterminée est l'extrémité de la mémoire elle-même; son adresse est celle du dernier mot de la dernière page ADF de la mémoire ou celle de cette dernière page si la mémoire est programmable par page, ou la dernière adresse de mot ADFM si la mémoire est programmable par mot.

Le client choisit l'adresse de page ADP à partir de laquelle les informations sensibles doivent être protégées. La zone protégée est alors la zone comprise entre l'adresse de page ADP et la fin de la mémoire, c'est-à-dire l'adresse de page ADF.

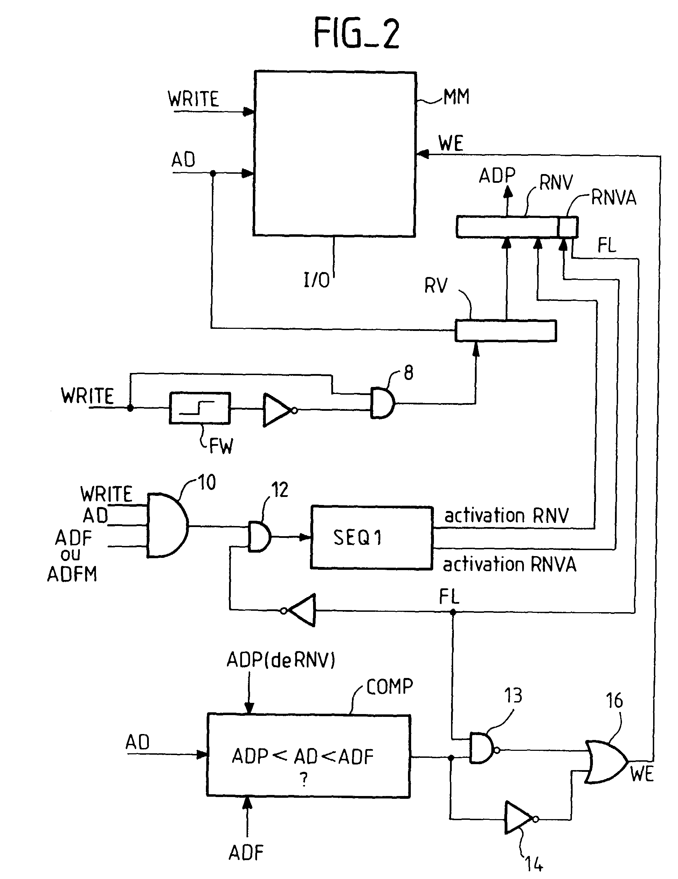

Le circuit est organisé (figure 2) avec les contraintes suivantes pour le client : il doit écrire les informations sensibles dans la mémoire MM en commençant nécessairement par un mot à l'adresse ADP de début de zone, car c'est la première adresse écrite qui impose automatiquement le début de zone protégée. Il écrit ensuite toutes les informations sensibles. Il termine par une écriture de mot à l'adresse ADF. C'est cette dernière écriture qui déclenche la mémorisation définitive de l'adresse ADP dans un registre non volatile qui est utilisé ensuite comme référence permanente indiquant les limites de la zone protégée pour contrôler l'accès à cette zone et laisser libre l'accès au reste de la mémoire.

Les moyens de partition de zone entre zone protégée et zone non protégée comportent un registre volatile RV dans lequel on inscrit la première adresse de page écrite par le client. C'est l'adresse ADP (6 bits d'adresse de page pour une adresse de mot qui peut comporter 11 bits) . Cette adresse reste dans le registre RV tant que le client continue à écrire les informations sensibles.

L'ordre d'écriture WRITE reçu par la mémoire sert à inscrire l'adresse ADP dans le registre RV. Le registre RV reçoit à cet effet les bits d'adresse de page de l'adresse courante AD appliquée à la mémoire MM. Mais pour que le contenu du registre RV ne soit pas modifié lors des écritures qui vont suivre, on prévoit que le signal de contrôle d'écriture dans le registre RV, qui peut être le signal WRITE lui-même, est inhibé après la première écriture. Cette inhibition peut être effectuée grâce à une bascule monostable FW inactive au départ (sortie à zéro) et qui bascule immédiatement (sortie à 1) après le premier ordre d'écriture; une porte ET 8 reçoit la sortie de la bascule FW et inhibe toute modification ultérieure du contenu du registre RV.

L'adresse enregistrée dans le registre RV est donc l'adresse ADP si le client suit la procédure normale.

Le client poursuit ensuite l'écriture des informations sensibles dans les adresses de la zone protégée désirée, c'est-à-dire entre l'adresse ADP et l'adresse de page ADF (programmation par page) ou ADFM (programmation par mot). Les mentions d'adresse de mot ADFM dans ce qui suit s'appliquent si la mémoire est programmable par mots.

Le client termine par une écriture à l'adresse ADF ou ADFM. Les moyens de partition comportent des moyens de détection d'écriture à l'adresse ADF ou ADFM. Cette détection active un séquenceur SEQ1 qui mémorise définitivement dans un registre non volatile RNV l'adresse ADP stockée provisoirement dans le registre RV. Ceci peut être fait, comme représenté schématiquement sur la figure 2, à l'aide d'une porte ET 10 qui reçoit l'adresse ADF ou ADFM, ainsi que l'adresse courante AD (page ou mot) reçue par la mémoire et qui reçoit également le signal WRITE. S'il y a écriture à l'adresse ADF (ou ADFM), la porte 10 s'ouvre et active le séquenceur SEQ1. Toutefois, cette activation n'a lieu que si l'opération de partition de mémoire n'a pas encore eu lieu. Un registre non volatile RNVA, qui peut être constitué par une case supplémentaire du registre RNV contient un drapeau non volatile FL, à zéro au départ, indiquant que la procédure de partition n'a pas encore eu lieu. Si le drapeau est activé, le séquenceur SEQ1 est inhibé, ce qui a été figuré par une porte ET 12 recevant la sortie inversée du registre RNVA et la sortie de la porte 10.

Le séquenceur SEQ1 active le drapeau non volatile FL du registre RNVA et transfère le contenu du registre volatile RV dans le registre non volatile RNV (six bits d'adresse de page de la deuxième moitié de la mémoire).

La partition est dès lors établie.

Si le client s'est trompé ou est en cours de test, ou s'il a toute autre raison de le faire, il peut empêcher l'activation du séquenceur SEQ1 en n'écrivant pas à l'adresse ADF (ou ADFM) et en coupant l'alimentation du circuit, ce qui remet le circuit dans son état initial comme si on n'avait pas tenté d'établir la partition de zones de mémoire. L'opération peut être recommencée au début.

Mais s'il écrit à l'adresse ADF (ou ADFM), la partition s'établit de manière définitive, le drapeau FL étant mis définitivement à 1.

Dans le cas d'un circuit à microprocesseur, l'ensemble des circuits nécessaires à la partition peut être réalisé sous forme d'une série d'instructions exécutées par ce microprocesseur pour écrire la première adresse dans le registre RV, détecter l'écriture à l'adresse ADF ou ADFM, lire le contenu du registre volatile RV, écrire ce contenu dans le registre RNV, et établir le drapeau FL à 1 dans la case RNVA. Cette série d'instruction peut aussi, sans microprocesseur, être réalisée sous la forme d'un circuit câblé de commande, genre machine d'états.

Lorsque la partition est réalisée, le circuit peut fonctionner en mode protégé : toute adresse AD reçue est comparée à l'adresse ADP dans un comparateur COMP. Si l'adresse est inférieure (zone non protégée), un signal d'autorisation d'écriture WE est transmis à la mémoire MM (par les portes 14 et 16) pour exécution d'un cycle d'écriture. Mais si l'adresse est supérieure à ADP, donc comprise entre les adresses de page ADP et ADF, une porte logique 18 permet d'inhiber le signal WE. Cette inhibition n'a lieu cependant que si la partition a été réalisée auparavant, ce qui est contrôlé par le drapeau RNVA d'activation de la partition : la porte 18 reçoit le contenu FL du registre RNVA; tant que ce contenu reste à zéro, l'autorisation d'écriture subsiste pour toutes les adresses de la mémoire.

On comprendra que l'adresse ADF (ou ADFM), qui représente la deuxième extrémité de la zone protégée, et qui est prédéterminée, pourrait très bien être différente de l'adresse finale de la mémoire. Ce peut être une adresse quelconque prédéterminée ADQ (adresse de page pour une programmation par page) ou ADQM (adresse de mot pour une programmation par mot). Mais il faut alors que le programmeur qui écrit les informations sensibles dans la zone protégée sache que dès qu'il écrit dans cette adresse particulière la partition est considérée comme réalisée, le séquenceur SEQ1 est activé, et la zone protégée est située entre cette adresse particulière et l'adresse contenue dans le registre volatile RV au moment de l'activation. Le programmeur doit donc en tenir compte lorsqu'il écrit les informations sensibles, la règle principale étant qu'il doit écrire en dernier dans l'adresse prédéterminée qui déclenche l'activation de la partition. La modification qui en résulte dans le circuit est le fait que le comparateur COMP examine si l'adresse courante est comprise entre ADP et ADQ pour inhiber le signal d'écriture WE.

On comprendra aussi que la zone protégée peut très bien être située non pas après la première adresse écrite ADP et jusqu'à l'adresse prédéterminée ADQ, mais avant l'adresse ADP et depuis une adresse prédéterminée qu'on peut appeler ADQ'. Le client doit programmer à partir de l'adresse ADP et la partition est établie lorsqu'il programme l'adresse ADQ' (ou ADQ'M). Il faut alors que le comparateur COMP inhibe l'accès à la mémoire lorsque l'adresse courante est comprise entre ADQ' et ADP.

### Deuxième mode de mise en oeuvre :

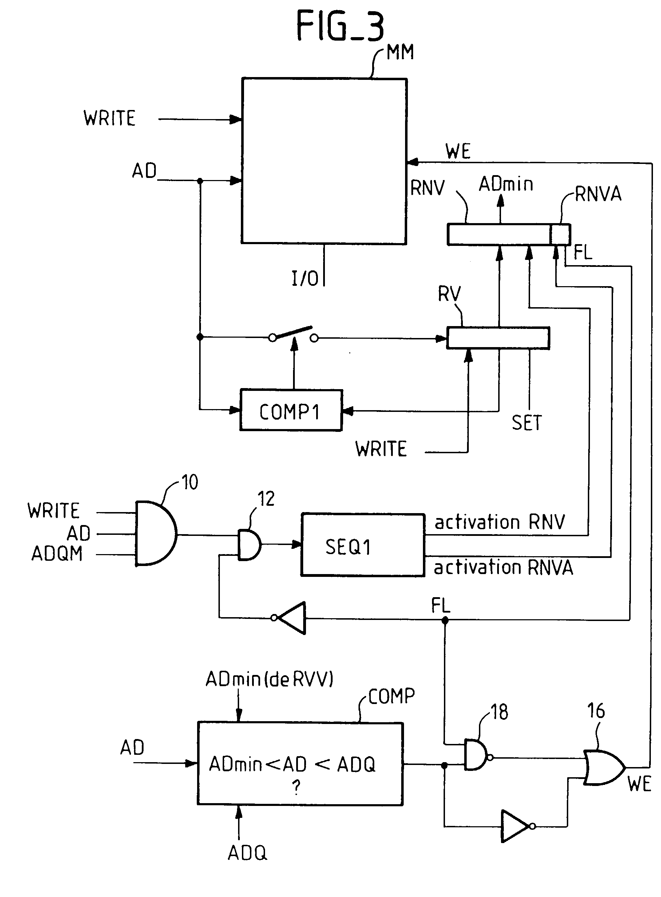

Pour montrer d'autres utilisations de l'invention, on propose ici de montrer, en référence à la figure 3, une autre manière d'obtenir une définition commode de l'emplacement de la zone protégée, et cette fois même sans commencer l'écriture des informations sensibles à une adresse particulière définissant une extrémité de la zone protégée.

Le client écrit les informations sensibles dans la zone protégée qu'il choisit. Il écrit en commençant n'importe où, et en évitant simplement de programmer l'adresse particulière ADQ (ou ADQM) qui va déclencher l'activation de la partition. Là encore, l'adresse ADQ ou ADQM peut être une adresse de fin de la mémoire ou de début de la mémoire ou toute autre adresse choisie à l'avance.

Le schéma de la figure 2 doit être modifié pour permettre de réécrire dans le registre volatile à chaque écriture dans la mémoire. La figure 3 représente le schéma modifié.

L'adresse de page qui est réécrite à chaque fois dans le registre volatile RV est la plus petite des deux valeurs suivantes : adresse courante de page et adresse de page déjà contenue dans le registre RV. Autrement dit, si on écrit à une adresse supérieure à l'adresse contenue dans le registre on laisse cette valeur dans le registre RV; si on écrit à une adresse inférieure, on écrit dans le registre RV la valeur de la nouvelle adresse de page. A la fin, le registre RV contient la plus petite valeur d'adresse de page ADmin utilisée par le programmeur pour stocker les informations sensibles. Le contenu du registre RV est transféré automatiquement dans le registre RNV au moment de l'écriture du dernier mot à l'adresse ADQM. La partition est activée et la zone protégée est située entre l'adresse ADmin et l'adresse prédéterminée ADQ. La longueur de la zone protégée s'est ajustée automatiquement à la longueur de la zone nécessaire au stockage des informations sensibles. Le client n'a pas besoin de s'imposer une programmation commençant par la plus petite adresse dont il aura besoin.

La figure 3 comporte un comparateur supplémentaire COMP1 qui reçoit l'adresse courante de page (6 bits de AD) et le contenu du registre RV pendant l'écriture des informations sensibles, et qui définit si le contenu du registre doit être modifié pour être remplacé par une adresse plus petite. Une bascule monostable peut inhiber ce comparateur lors de la première comparaison si le registre est initialement à zéro, car il faut stocker une première adresse dans le registre avant de commencer les comparaisons. Alternativement on peut s'arranger pour mettre le registre à une valeur initiale maximale (suite de 1) lors de la mise sous tension du circuit, donc avant la première écriture; ceci est figuré par une commande SET du registre RV, établie à la mise sous tension du circuit.

Pour le reste, le circuit fonctionne comme cela a été décrit à propos de la figure 2. Les variantes mentionnées à propos de la figure 2 sont transposables à la figure 3 : l'adresse prédéterminée qu'on programme en dernier pour déclencher l'activation de la partition peut être une adresse ADQ ou ADQM quelconque autre que la dernière adresse ADF ou ADFM de la mémoire; d'autre part le registre RV peut être rempli à chaque fois avec la plus grande et non la plus petite des deux valeurs entre la valeur déjà contenue dans le registre et la valeur d'adresse courante; dans ce cas, le registre RV est initialisé à zéro plutôt qu'à 1 par la commande SET; l'adresse prédéterminée ADQ' ou ADQ'M est l'adresse de début de zone protégée et non l'adresse de fin, mais c'est toujours à cette adresse prédéterminée qu'il faut faire la dernière opération d'écriture qui active la partition.

Les circuits des figures 2 et 3 sont donnés à titre d'exemples schématiques permettant d'expliquer le fonctionnement de l'invention. Leur réalisation pratique peut être très variable. Par exemple, les registres RNV et RNVA peuvent être des mots d'une extension de la mémoire MM, mots qui peuvent être écrits et lus grâce à des adresses différentes de celles qui définissent le plan mémoire accessible à l'utilisateur. Dans ce cas, on comprend que les fonctions représentées par des éléments et des connexions simples sur les figures 2 et 3 sont en pratique réalisées par des séquenceurs plus complexes. Ainsi, il faut comprendre que toute opération d'écriture dans la mémoire MM passe par une lecture préalable du drapeau FL du registre RNVA, et une lecture du contenu du registre RNV. Ces contenus sont alors utilisés pour déterminer si l'accès en écriture est autorisé; ceci a été représenté très schématiquement sur les figures 2 et 3 par de simples portes logiques et comparateurs reliés aux registres RNV et RNVA.

Dans tout ce qui précède on a considéré qu'il n'y a qu'une valeur possible de l'adresse prédéterminée ADF ou ADQ (ADFM ou ADQM) dans un circuit donné. On peut cependant imaginer aussi que la valeur ADQ ou ADQM peut être définie par l'utilisateur lui-même préalablement à l'opération de partition définie ci-dessus. Cette définition peut se faire par programmation ou par tout autre moyen. Cela impose cependant une contrainte supplémentaire au client. On peut prévoir par exemple que la première écriture dans une adresse quelconque de la mémoire définit l'adresse prédéterminée ADQ et que c'est la deuxième écriture qui est considérée comme première écriture au sens de tout ce qui a été décrit ci-dessus. Les circuits des figures 2 et 3 peuvent facilement être adaptés en fonction de cette contrainte supplémentaire.

## Revendications

1. Procédé pour réaliser une partition d'une mémoire entre une zone protégée et une zone non protégée, dans un circuit intégré à mémoire (MM) comportant des moyens pour empêcher ou autoriser (COMP) un accès à des adresses (AD) de mémoire (MM) selon qu'elles sont situées dans la zone protégée ou dans la zone non protégée, la zone protégée étant définie par deux adresses d'extrémité de zone dont l'une est prédéterminée (ADFM, ADQM) et l'autre est à choisir (ADP), ce procédé comportant les opérations consistant à :
a) - écrire dans la mémoire à des adresses successives dans la zone protégée désirée,
c) - effectuer une dernière opération d'écriture à l'adresse prédéterminée représentant une extrémité de la zone protégée;
caractérisé en ce que, entre l'étape a) et c), on effectue l'étape
b) - consistant à écrire automatiquement dans un registre volatile (RV) initialement la valeur de la première adresse à laquelle on a écrit;
et en ce que, après l'étape c), on effectue l'étape
d) - consistant à transférer automatiquement vers un registre non volatile (RNV) l'adresse contenue dans le registre volatile (RV), lors de l'opération d'écriture dans l'adresse prédéterminée, la zone protégée étant dès lors comprise entre l'adresse placée dans le registre non volatile et l'adresse prédéterminée.

2. Procédé selon la revendication 1, caractérisé en ce qu'entre l'étape b) et l'étape c) on effectue l'étape récurrente b1) consistant à modifier à chaque écriture le contenu du registre volatile (RV) pour y placer la plus faible ou la plus forte des deux valeurs suivantes : adresse en cours d'écriture et adresse contenue dans le registre volatile (RV).

3. Circuit intégré à mémoire comportant des moyens (COMP, RNV) pour limiter l'accès à une zone protégée de la mémoire (MM), ces moyens utilisant un registre non-volatile (RNV) contenant une adresse (ADP) d'extrémité de la zone protégée, caractérisé en ce que le circuit comporte des moyens pour définir une partition souhaitée de la mémoire entre cette zone protégée et une zone non protégée, ces moyens comportant un séquenceur (SEQ1), activé automatiquement par une opération d'écriture dans une adresse prédéterminée (ADFM, ADQM) de la mémoire après des opérations d'écriture d'informations sensibles dans une série d'autres adresses de la zone protégée souhaitée, le séquenceur étant apte à stocker dans le registre non-volatile (RNV) une adresse spécifique (ADP) définie à partir des adresses de la série, l'adresse spécifique correspondant à la première adresse de la série et étant préalablement mémorisée dans un registre volatile (RV).

4. Circuit intégré selon la revendication 3, caractérisé en ce qu'il comporte des moyens (FW, RV), pour stocker dans un registre volatile la première adresse à laquelle on écrit une information sensible, le séquenceur comportant en outre des moyens pour transférer le contenu du registre volatile dans le registre non volatile.

5. Circuit selon la revendication 4, caractérisé en ce qu'il comporte des moyens pour remplacer à chaque opération d'écriture d'une information sensible le contenu du registre volatile par la valeur d'adresse d'écriture courante si cette valeur est plus petite que la valeur contenue dans le registre.

6. Circuit selon la revendication 4, caractérisé en ce qu'il comporte des moyens pour remplacer à chaque opération d'écriture d'une information sensible le contenu du registre volatile par la valeur d'adresse d'écriture courante si cette valeur est plus grande que la valeur contenue dans le registre volatile.

7. Circuit selon l'une des revendications 3 à 6, caractérisé en ce qu'il comporte une cellule de registre non volatile (RNVA) programmée par le séquenceur, pour contenir un drapeau non volatile indiquant que la partition de la mémoire entre une zone protégée et une zone non protégée est en service, et des moyens permettant l'inhibition d'écriture dans la zone protégée si le drapeau est activé.

## Patentansprüche

1. Verfahren zum Aufteilen eines Speichers in einen geschützten Bereich und einen nicht geschützten Bereich in einem integrierten Speicherschaltkreis (MM) mit Mitteln, um einen Zugriff auf Adressen (AD) des Speichers (MM) zu verhindern oder freizugeben (COMP), je nachdem ob sie in dem geschützten Bereich oder in dem nicht geschützten Bereich liegen, wobei der geschützte Bereich durch zwei Endadressen des Bereiches definiert ist, von denen eine vorgegeben ist (ADFM, ADQM) und die andere wählbar ist (ADP), wobei dieses Verfahren die folgenden Operationen umfaßt:
a) Schreiben in dem Speicher unter aufeinanderfolgenden Adressen in dem gewünschten geschützten Bereich,
c) Ausführen einer letzten Schreiboperation bei der vorgegebenen Adresse, die ein Ende des geschützten Bereiches darstellt,
dadurch gekennzeichnet, daß
zwischen dem Schritt a) und c) der Schritt
b) ausgeführt wird, der darin besteht, automatisch in ein flüchtiges Register (RV) ursprünglich den Wert der ersten Adresse, bei der man schreibt, einzuschreiben; und daß nach Schritt c) der Schritt
d) durchgeführt wird, der darin besteht, automatisch in ein nicht-flüchtiges Register (RNV) die Adresse in dem flüchtigen Register (RV) zu übertragen, wenn die Schreiboperation bei der vorgegebenen Adresse erfolgt, wobei der geschützte Bereich zwischen der in dem nicht-flüchtigen Register befindlichen Adresse und der vorgegebenen Adresse liegt.

2. Verfahren nach Anspruch 1, dadurch gekennzeichnet, daß zwischen Schritt b) und c) der rekursive Schritt b1) ausgeführt wird, der darin besteht, bei jedem Schreiben den Inhalt des flüchtigen Speichers (RV) zu modifizieren, um dort den kleinsten oder größten von zwei folgenden Werten anzuordnen: Adresse im Verlauf des Schreibens und Adresse, die in dem flüchtigen Register (RV) enthalten ist.

3. Integrierter Speicherschaltkreis mit Mitteln (COMP, RNV), um den Zugriff auf einen geschützten Bereich des Speichers (MM) zu beschränken, wobei diese Mittel auf ein nicht-flüchtiges Register (RNV) zurückgreifen, das eine Adresse (ADP) des Endes des geschützten Bereiches enthält, dadurch gekennzeichnet, daß der Schaltkreis Mittel zum Definieren einer gewünschten Aufteilung des Speichers in diesem geschützten Bereich und einen nicht geschützten Bereich umfaßt, wobei diese Mittel einen Sequenzierer (SEQ1) enthalten, der automatisch durch eine Schreiboperation bei einer vorgegebenen Adresse (ADFM, ADQM) des Speichers nach Schreiboperationen von sensiblen Informationen bei einer Folge von anderen Adresse des gewünschten geschützten Bereiches aktiviert wird, wobei der Sequenzierer dazu geeignet ist, in dem nicht-flüchtigen Register (RNV) eine spezielle Adresse (ADP), die ausgehend von den Adressen der Reihe definiert ist, abzuspeichern, wobei die spezielle Adresse der ersten Adresse der Reihe entspricht und vorher in einem flüchtigen Register (RV) abgelegt worden ist.

4. Integrierter Schaltkreis nach Anspruch 3, dadurch gekennzeichnet, daß er Mittel (FW, RV) umfaßt, um in ein flüchtiges Register die erste Adresse zu speichern, bei der eine sensible Information geschrieben wird, wobei der Sequenzierer außerdem Mittel umfaßt, um den Inhalt des flüchtigen Registers in das nicht-flüchtige Register zu übertragen.

5. Schaltkreis nach Anspruch 4, dadurch gekennzeichnet, daß er Mittel umfaßt, um bei jeder Schreiboperation einer sensiblen Information den Inhalt des flüchtigen Registers durch den Wert der laufenden Schreibadresse zu ersetzen, wenn dieser Wert kleiner als der Wert in dem Register ist.

6. Schaltkreis nach Anspruch 4, dadurch gekennzeichnet, daß er Mittel umfaßt, um bei jeder Schreiboperation einer sensiblen Information den Inhalt des flüchtigen Registers durch den Wert der laufenden Schreibadresse zu ersetzen, wenn dieser Wert größer als der Wert in dem flüchtigen Register ist.

7. Schaltkreis nach einem der Ansprüche 3 bis 6, dadurch gekennzeichnet, daß er eine nicht-flüchtige Registerzelle (RNVA) umfaßt, die durch den Sequenzierer programmiert ist, um ein nicht-flüchtiges Flag zu enthalten, das anzeigt, daß die Aufteilung des Speichers in einen geschützten Bereich und einen nicht geschützten Bereich momentan vorgenommen wird, und Mittel, die das Inhibieren von Schreiben in den geschützten Bereich ermöglichen, wenn das Flag aktiviert ist.

## Claims

1. Method for effecting a partitioning of a memory between a protected area and a non-protected area, in an integrated circuit with a memory (MM) having means for preventing or enabling (COMP) access to addresses (AD) in the memory (MM) depending on whether they are situated in the protected area or in the non-protected area, the protected area being defined by two end-of-area addresses, one of which is predetermined (ADFM, ADQM) and the other one of which is to be chosen (ADP), this method including the operations consisting of:
a) - writing in the memory at successive addresses in the required protected area,
c) - performing a last operation of writing at the predetermined address representing an end of the protected area;
characterised in that, between step a) and c), step b) is performed, consisting of automatically writing in a volatile register (RV) initially the value of the first address at which writing was performed;
and in that, after step c), step d) is performed, consisting of automatically transferring, to a non-volatile register (RNV), the address contained in the volatile register (RV), during the operation of writing in the predetermined address, the protected area consequently being situated between the address placed in the non-volatile register and the predetermined address.

2. Method according to Claim 1, characterised in that, between step b) and step c), the recurrent step b1) is performed, consisting of modifying the content of the volatile register (RV) at each writing in order to place therein the lowest or highest of the following two values: the address currently being written and the address contained in the volatile register (RV) .

3. Integrated circuit with a memory having means (COMP, RNV) for limiting access to a protected area of the memory (MM), these means using a non-volatile register (RNV) containing an end address (ADP) of the protected area, characterised in that the circuit has means for defining a required partitioning of the memory between this protected area and a non-protected area, these means including a sequencer (SEQ1), activated automatically by an operation of writing in a predetermined address (ADFM, ADQM) of the memory after operations of writing sensitive information in a series of other addresses of the required protected area, the sequencer being able to store, in the non-volatile register (RNV), a specific address (ADP) defined from addresses in the series, the specific address corresponding to the first address of the series and being stored in advance in a volatile register (RV).

4. Integrated circuit according to Claim 3, characterised in that it has means (FW, RV) for storing, in a volatile register, the first address at which sensitive information was written, the sequencer also having means for transferring the content of the volatile register into the non-volatile register.

5. Circuit according to Claim 4, characterised in that it has means for replacing, at each operation of writing sensitive information, the content of the volatile register with the current writing address value if this value is smaller than the value contained in the register.

6. Circuit according to Claim 4, characterised in that it has means for replacing, at each operation of writing sensitive information, the content of the volatile register with the current writing address value if this value is larger than the value contained in the volatile register.

7. Circuit according to one of Claims 3 to 6, characterised in that it includes a non-volatile register cell (RNVA) programmed by the sequencer, for containing a non-volatile flag indicating that the partitioning of the memory between a protected area and a non-protected area is in service, and means for inhibiting writing in the protected area if the flag is activated.
